# EUROPEAN PATENT APPLICATION

(11) **EP 1 215 705 A2**
(43) Date of publication of application: **19.06.2002**
(21) Application number: 01128703.4
(22) Date of filing: 01.12.2001
(51) Int. Cl.: H01J 29/86

(54) **Transparent electromagnetic radiation shielding material**

(30) Priority: 12.12.2000 JP 2000377501
(71) Applicant: NISSHINBO INDUSTRIES, INC., Chuo-ku, Tokyo (JP)
(72) Inventor: Marutsuka, Toshinori, Midori-ku, Chiba-shi, Chiba (JP)
(74) Representative: Leifert, Elmar, Dr.

(57) **Abstract**

A transparent electromagnetic radiation shielding material is disclosed. The material comprises an identical mesh-pattern laminated layer consisting of a black layer/metallic layer or a metallic layer/black layer or a black layer/metallic layer/black layer. The laminated layer is sequentially formed by dry plating and is formed so that identical mesh patterns match with each other.

## Description

### BACKGROUND OF THE INVENTION

### 1. Field of the Invention

This invention relates to a transparent electromagnetic radiation shielding material, more particularly to a transparent electromagnetic radiation shielding material for placement in front of a display device or other sources of electromagnetic radiation to shield the viewer from electromagnetic radiation. This invention is especially suitable for use with a large plasma display panel.

### 2. Discussion of the Related Art

An electromagnetic radiation shielding material to be placed in front of displays are required to have excellent transparency (optical transmittance) and high clarity (degree of blackness of black layer) in addition to high electromagnetic radiation shielding capability. Japanese Patent Application Laid-Open Nos. 11-298185 and 1-170098 (JP 11-298185 and JP 1-170098) teach an electromagnetic radiation shielding material meeting these requirements to some extent. The invention described in JP 11-298185 is directed to a transparent electromagnetic radiation shielding material in which at least a black layer having either of metal oxide or metal sulfide and a metallic thin film layer are laminated one after another so as to form an electromagnetic radiation shield pattern on a transparent base material.

The invention described in JP 1-170098 is directed to an electromagnetic radiation shielding transparent sheet in which a transparent conductive film and a conductive grid pattern are formed on a transparent plate.

However, the electromagnetic radiation shielding material described in JP 11-298185 has the following problems:
1) Adhesion of the black layer to the transparent base material is low. When patterning the electromagnetic radiation shielding material including a metallic layer to form an electromagnetic radiation shield pattern (mesh-like pattern) or when adhering to and laminating with functional materials other than electromagnetic shielding material (near infrared cutoff material, antireflection layer, etc.), some layers may be peeled off.
2) It is hard to obtain high clarity (sufficient blackness of black layer) due to the limitation of the combination of usable transparent base materials and black layers.
3) Production yield is low and production cost is high.

Also, the electromagnetic radiation shield transparent sheet described in JP 1-170098 has the following problems:
1) Electromagnetic radiation shielding performance is extremely low (a little improvement in electromagnetic radiation shielding performance may be observed at a low frequency (long wavelength) but it is hardly observed at a frequency of 500 MHz).
2) Clarity is extremely poor (grid patterns are visibly seen and obstruct the view).
3) It cannot be used for use with displays such as PDP.

### SUMMARY OF THE INVENTION

The inventor have achieved the present invention as a result of a number of diligent studies and his continuous efforts in developing a transparent electromagnetic radiation shielding material that overcomes such drawbacks of the prior art. Specifically, the present invention relates to a transparent electromagnetic radiation shielding material comprising an identical mesh-pattern laminated layer consisting of a black layer/metallic layer or a metallic layer/black layer or a black layer/metallic layer/black layer, in which the identical mesh-pattern laminated layer is formed by dry plating in order on a transparent surface layer formed on a transparent base material.

The transparent base materials used in the transparent electromagnetic radiation shielding materials of the present invention are chosen depending on uses. Examples of the transparent base materials include glass plate, plastic film, plastic sheet, plastic plate, etc. The shape of the base material is not also particularly limited.

Preferable plastics used for the transparent base material are resins having a high transparency. Examples of such resins include acrylic resin, polycarbonate, polyethylene, AB resin, vinyl acetate resin, polystyrene, polypropylene, polyester, polysulfone, polyethersulfone, polyvinylchloride, olefine-maleimide copolymer, norbornene resin. Among these, olefine-maleimide copolymer and norbornene resin are preferably used since they have excellent heat-resistance.

The plastic should preferably have a thermal-deformation temperature of 140-360 °C, a coefficient of thermal linear expansion of not greater than 6.2 × 10⁻⁵ cm/cm·°C, a pencil hardness of not less than 2H, a bending strength of 120-200 N/mm², a modulus of elasticity in bending of 3,000-5,000 N/mm² and a tensile strength of 70-120 N/mm². Such plastic can be used in a wide range of environments since it is resistant to high-temperature warping and scratching.

The plastic preferably has a light transmittance of not less than 90%, an Abbe's number of 50-70 and a photoelasticity constant (glass region) of an absolute value of not greater than 10×10⁻⁸ cm²/N. Such plastic exhibits high transparency (bright) and little birefringence (less likely to produce a double image) and therefore does not degrade the image quality, brightness, etc. of the display.

The thickness of the transparent base material is normally selected in the range of 0.05-10 mm. The thickness of less than 0.05 mm is not preferable because it is difficult to handle. The thickness exceeding 10 mm is also not preferable because it becomes heavy. The preferable thickness is in the range of 0.1-5 mm.

The transparent surface layer used in the transparent electromagnetic radiation shielding material of the present invention comprises either at least one of transparent resin layer, at least one of transparent inorganic layer (including one that is common to transparent conductive layer) or at least one of transparent conductive layer. The transparent surface layer is provided to improve the adhesion of the layers formed thereon, such as a black layer/metallic layer and a metallic layer/black layer and a black layer/metallic layer/black layer, and to reduce the stress of the layers. When a transparent conductive layer is used for the transparent surface layer, the transparent surface layer is also provided to improve electromagnetic radiation shielding performance. The type, thickness and producing method of the transparent surface layer are not limited insofar as they have sufficient transparency and film properties (heat resistance, chemical resistance, intensity, hardness, resistivity, etc.).

Usable layers are discussed below:
(1) Transparent resin layer
   (i) Type: one of or two or more of polyvinylacetate, acrylic, polyester, epoxy, cellulose, vinylacetate, polycarbonate, polyimide, polycarboxyimide type resins, preferably polyvinylacetate and/or polycarboxyimide type resins (organic or inorganic or metallic particles can be dispersed therein in an attempt to reduce the stress of the resin film, to improve the hardness of the resin film, to provide electrical conductivity with the resin film, etc. insofar as they do not degrade the transparency)
   (ii) Thickness: 0.1-10 µm, preferably 0.5-5 µm (The resin film becomes repellent at the thickness of less than 0.1 µm. At the thickness exceeding 10 µm, a citrus skin may be observed.)
   (iii) Method of forming: Applying a resin solution by a normal coating method (dip coating, spin coating, dye coating, roll coating, bar coating, spray coating, etc.) and drying the resin solution
(2) Transparent inorganic layer
   (i) Type: one of or two or more of silicon dioxide, titanium oxide, aluminum oxide, tantalite oxide, zirconium oxide, tin oxide, indium oxide, zinc oxide, magnesium fluoride
   (ii) Thickness: 10-1,000 nm, preferably 20-500 nm (pinholes may occur at the thickness of less than 10 nm and cracks may occur at the thickness exceeding 1,000 nm)
   (iii) Method of forming: dry plating, sol-gel process
(3) Transparent conductive layer
   (3-1) Transparent resin layer having conductive particle dispersed
      (i) Type: ones that are prepared from the transparent resin of type (1) above and have conductive particles dispersed in the transparent resin of type (1) (conductive particles are one of or two or more of gold, silver, copper, tin oxide, indium oxide, zinc oxide; the grain size is less than 1/10 of the thickness of the resin layer; and the content is in a range that does not degrade the transparency)
      (ii) Thickness: the same as that of the transparent resin layer in type (1) above
      (iii) Method of forming: the same as that of the transparent resin layer in type (1) above
   (3-2) Metallic thin layer, metal oxide layer, metal sulfide layer, etc.

The metals composing the metallic layer preferably have a resistivity of not less than 2.5 × 10⁻⁶ Ω·cm. Examples of such metals include gold, silver, steel or an alloy of these metals. The thickness of the metallic thin layer is normally 5-100 nm, preferably in the range of 10-50 nm (at a thickness of less than 5 nm, pinholes often occur and the conductivity is low; at a thickness exceeding 100 nm, the transparency is low).

Preferable examples of the metal oxide include zinc oxide, indium oxide, tin oxide, ITO (indium tin oxide), ATO (antimony tin oxide), FTO (fluorine tin oxide), IZO (indium zinc oxide). The thickness of the metal oxide layer or the metal sulfide layer is normally 10-1,000 nm, preferably 20-500 nm (at a thickness of less than 10 nm, pinholes often occur and the conductivity is low; at a thickness exceeding 1,000 nm, cracks may occur).

These layers are formed by dry plating, such as vapor deposition, spattering, ion plating, etc.

It has been noted that the visible light transmittance or the near infrared cutoff performance of the metallic thin layer is improved when the metallic thin layer is used with the metal oxide layer or the metal sulfide layer which are laminated so as to hold the metallic thin layer between the metal oxide layer or the metal sulfide layer by laminating one after the other. Such metal thin layer may also be used in such manner.

The metallic layer used in the transparent electromagnetic radiation shielding material of the present invention is used to provide electromagnetic radiation shielding capability. The metallic layer used herein is not particularly limited as regards type, color, thickness and producing method of the metal insofar as etching can be carried out. Preferable metallic layers include a single layer or a laminated layer comprising one of or two or more of metals having a resistivity of not greater than 1.0×10⁻⁴ Ω·cm, such as copper, nickel, iron, chromium, titanium, aluminum, gold, silver, etc. Among these, copper is particularly preferable from the points of view including its electromagnetic radiation shielding capability (resistivity), etching ease, cost efficiency, etc. In addition, considering a corrosion resistivity of the metallic layer, a metallic layer having such a structure that copper is held between metals having a high corrosion-proofness, such as chromium, nickel, etc. is also preferable. Generally, the metallic layer has a high conductivity (low resistivity) and exhibits a higher shielding capability with the thicker layer and a high etching capability with the thinner layer. When a resistivity exceeds 1.0×10⁻⁴ Ω·cm, it is difficult to satisfy both the high electromagnetic radiation shielding capability (etching capability) and the mesh patterning capability at the same time.

The metallic layer is formed depending on the required thickness, adhesion, etc. by dry plating, such as one of or a combination of two or more of ion plating, spattering, vapor deposition, etc.

The pattern and the aperture ratio of the metallic layer are not particularly limited insofar as they are within ranges ensuring sufficient electromagnetic radiation shielding performance and optical transmittance are obtained. Even a parallel line pattern, for example, provides a shielding effect (exhibiting directionality in the near field). Since the effect is insufficient, however, a mesh-like (grid like) pattern is normally used. Various basic mesh-like patterns are available, including grid (tetragonal), triangular, polygonal, circular and elliptical.

The aperture ratio (the ratio of a non-metallic layer portion area relative to a repeated pattern unit area) is determined by a line width and a line interval (opening width) of the metallic layer pattern. Different patterns with the same aperture ratio have the same optical transmittance. Since the electromagnetic radiation shielding performance increases with decreasing the opening width, a narrower opening width is normally preferable.

In case that a grid-like pattern is used, the opening width is preferably not greater than 200 µm, more preferably not greater than 100 µm. The lower limit of the opening width is not particularly limited insofar as patterning can be carried out; however, it is normally about 10 µm, considering the lower limit of the line width and the aperture ratio.

In case of widening the opening width, the shielding performance is necessarily degraded as the aperture ratio (optical transmittance) is increased; however, in case of narrowing the opening width, the shielding performance can be enhanced while the aperture ratio (optical transmittance) is increased.

The line width is preferably not greater than 50 µm, more preferably 25 µm. The line width is determined as the opening width and the aperture ration are set. The lower limit is not particularly limited; however, it is normally about 2 µm, considering patterning ease.

The thickness of the line is preferably not greater than 10 µm, more preferably not greater than 5 µm. The aspect ratio of line thickness/line width is set not greater than 0.5 considering the patterning ease, viewing angle, etc. (since the higher the aspect ratio is, the lower patterning capability is obtained and the narrower viewing angle is observed). The lower limit of the line thickness is not particularly limited; however, it is normally about 0.5 µm, considering shielding performance, etc.

Nonetheless, these conditions are finally decided to fall within the range that does not cause occurrence of Moiré fringes when the electromagnetic radiation shielding is disposed on the front of the display panel.

The black layer used in the transparent electromagnetic radiation shielding material of the present invention comprises a black metallic oxide layer or a black metal sulfide layer. This layer comprising the black metallic oxide layer or the black metal sulfide layer (which is not used with a meaning of "an oxide or a sulfide of a black metal" but rather "metal oxide or metal sulfide in black") is formed in an attempt to ensure good visibility (viewing comfortableness) such as antireflection, etc. This black layer is provided (laminated) on the metallic layer and is not a blackened layer obtained by an oxidation treatment to a part of the metallic layer (surface layer).

Usable black metal oxides or black metal sulfides can be of any type, thickness, producing method, etc. insofar as they have sufficient blackness with a metallic layer being laminated thereon and mesh patterning can be carried out. One of or a combination of two or more of oxides of metal such as copper, nickel, cobalt, iron, palladium, platinum, indium, tin, titanium, chromium, etc. are appropriate. Among these, copper oxide, tin oxide, chromium oxide, copper sulfide, iron sulfide and nickel sulfide are preferable in view of the mesh patterning capability and the cost efficiency.

Although some of the metal oxide layers or the metal sulfide layers (many of them exhibit insulating capability) exhibit low conductivity (tin oxide, copper sulfide, etc.), a good electromagnetic radiation shielding capability is hard to obtain with such metal oxide layers or metal sulfide layers. Therefore, the metal oxide layers or the metal sulfide layers are obviously distinguished from metallic layers in view of the objects to be achieved and the conductivity.

The thickness of the black layer (black metal oxide layer or black metal sulfide layer) is normally 0.01-1 µm, preferably 0.05-0.5 µm. At a thickness of less than 0.01 µm, many pinholes are observed and the blackness is insufficient. At a thickness exceeding 1 µm, treatment cost becomes high.

The black layer (black metal oxide layer or black metal sulfide layer) is formed by one of or a combination of two or more of the methods of vapor deposition, spattering, ion plating, etc.

The black layer (black metal oxide layer or black metal sulfide layer) of the formed article preferably has a degree of blackness, expressed as optical density, of not less than 2.9 (angle of incidence of 7°; assuming no specular reflection). When the optical density is less than 2.9°, the blackness is low and ultimate clarity of the transparent electromagnetic radiation shielding material is poor (with a lower optical density, the metallic layer exhibits strong luster, causing it too bright). The optical density of not less than 2.9, the blackness is sufficiently high and excellent clarity is obtained (high definition). At the optical density exceeding 4.0, however, further substantial improvement of the clarity is not recognized by naked eyes.

The black layer itself may be transparent and its degree of blackness does not need to be not less than 2.9. (A sufficient degree of blackness is often observed when the metallic layer is laminated. Also, the independent black layer may be used for a transparent surface layer, like tin oxide, depending on composition.)

To form the identical and matched mesh-like pattern of one of the black layer/metallic layer, the metallic layer/black layer and the black layer/metallic layer/black layer (herein after these three types of the combination of layers may be called "the combination of metallic layers" as a general term) that is formed on the transparent surface layer formed on the transparent base material, it is possible to conduct direct treatment using laser, etc. after the metallic layer and the others; however, following method(A) blasting and/or etching method or method (B) liftoff method is normally used.

### Method (A)

After the combination of metallic layers is laminated, first, a mesh-pattern resist portion is formed thereon. The resist portion is formed by a commonly known method such as printing, photolithography, etc.

Next, the combination of metallic layers is patterned into a mesh-like pattern that is matched to the resist portion by blasting and/or etching (dissolving using an etching solution), etc. (to remove the non-resist portion). Last, the resist portion is removed by soaking in a peeling solution such as alkali aqueous solution, etc. or by applying the peeling solution by spraying.

When the combination of metallic layers is treated by blasting, the surface of the non-resist portion of the transparent base material or the transparent surface layer is roughened (whitened). In such case, a transparent resin can be used for coating the roughened (whitened) surface to achieve transparency. The treating conditions of blasting and etching are not particularly limited and are appropriately selected depending on type of the black layer and the metallic layer.

### Method (B)

A resist pattern that is opposite to the mesh-like pattern on the transparent surface layer formed on the transparent base material is formed before laminating the combination of metallic layers. After laminating the combination of metallic layers on the transparent surface layer and the resist layer, the resist (and the metallic layer and the others formed thereon) is peeled off so that only the mesh-like pattern of the combination of metallic layers remains on the transparent surface layer. The methods and conditions of forming the resist pattern portion are similar to those in Method (A) above.

In this method, the mesh-like pattern of the combination of metallic layers can be obtained by simply peeling off the resist pattern layer (and the combination of metallic layers formed thereon) that has the opposite pattern to the mesh-like pattern so that blasting and etching processes are not necessary. Therefore, the number of production step is significantly reduced. As a result, the process accuracy and the production yield increase compared to Method (A) above.

To peel off and remove only the resist layer (and the combination of metallic layers formed thereon), the thickness of the combination of metallic layers is not greater than 5 µm, preferably not greater than 3 µm. A thickness exceeding 5 µm degrades handling ease (a part of the non-resist portion of the combination of metallic layers formed on the transparent surface layer is peeled off). There is no lower limit of the thickness as for as handling ease is concerned (handling ease increases with a thinner layers) and is determined depending on the required shielding performance. To form such thinner layer (not greater than 5 µm) ensuring sufficient blackness, a black metal oxide layer or a black metal sulfide layer is preferably used. The black metal oxide layer or the black metal sulfide layer is normally laminated by dry plating such as ion plating, spattering, vapor deposition, etc.

By the foregoing method, the shielding material having the mesh-like pattern of the combination of metallic layers is fabricated. When the shielding material is used for placement in front of displays, earth portions need to be provided. In case that the outermost layer is the black layer, a portion of the black layer (in many cases, a frame portion) is removed by a widely known method (blasting, etc.) to expose the metallic layer (conductive portion).

The transparent electromagnetic radiation shielding material preferably have an optical transmittance of not less than 65 % and a shielding performance of not less than 40 dB (not less than 50 dB at 500 MHz) in the range of 30-1,000 MHz. An optical transmittance of less than 65 % is too dark. A shielding performance of less than 40 dB (30-1,000 MHz) is not sufficient for practical applications.

The above-discussed methods can be applied to a transparent film to form a transparent electromagnetic radiation shielding film. Such transparent electromagnetic radiation shielding film can then be adhered to a display panel or a transparent base material via an intervening transparent adhesion, if necessary, to fabricate transparent electromagnetic radiation shielding panel. Usable transparent film is preferably one that is provided as a continuous web and can be continuously processed into a roll. Examples of such films include plastic films having a thickness in the approximate range of 50-300 µm and made of polyethylene terephthalate (PET), polyimide (PI), polyethersulfone (PES), polyether-etherketone (PEEK), polycarbonate (PC), polypropylene (PP), polyamide, acryl, cellulose propionate (CP) and cellulose acetate (CA).

### BRIEF DESCRIPTION OF THE DRAWINGS

Next, the above and other objects and features of the transparent electromagnetic radiation shielding material obtained by the present invention will be clearly understood from the following description with respect to the preferred embodiments thereof when considered in conjunction with the accompanying drawings, in which:
Fig. 1 shows a cross sectional view of an embodiment of the transparent electromagnetic radiation shielding material of the present invention; and
Fig. 2 shows a cross sectional view of another embodiment of the transparent electromagnetic radiation shielding material of the present invention.

### DETAILED DESCRIPTION OF THE PREFERRED EMBODIMENTS

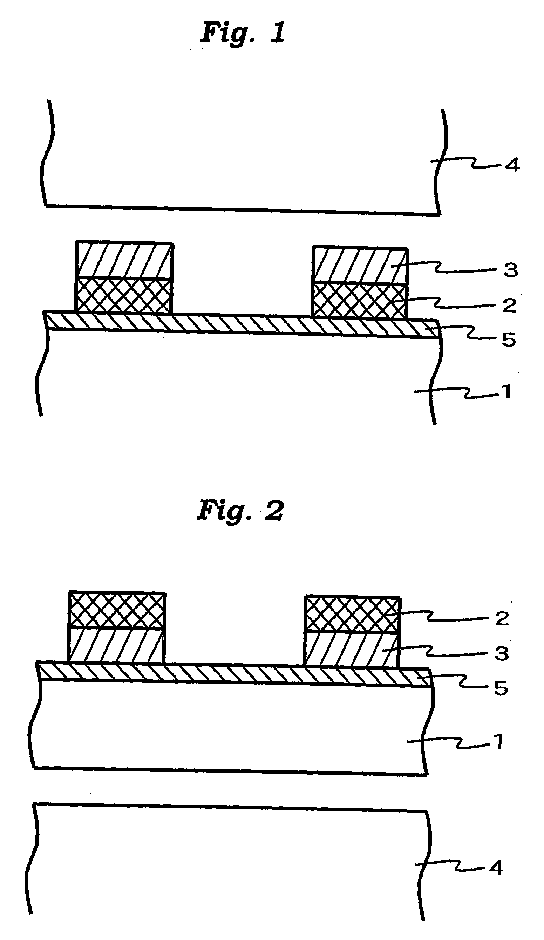

Figs. 1 and 2 show a cross sectional structure of the transparent electromagnetic radiation shielding material of the present invention.

Fig. 1 shows that a black layer 2 and a metallic layer 3, both layers having identical and matched mesh-like patterns, are formed by dry plating on a transparent surface layer 5 formed on a transparent base material 1. In Fig. 1, the black layer and the metallic layer are formed on a side of the transparent base material that is close to a display.

Fig. 2 shows that a metallic layer 3 and a black layer 2, both layers having identical and matched mesh-like patterns, are similarly formed as discussed in Fig. 1 above. In Fig. 2, the metallic layer and the black layer are formed on a side of the transparent base material that is away from a display.

In case that a black layer/metallic layer/black layer is used, the black layer/metallic layer/black layer can be formed on either sides, one close to a display or one away from the display, of the transparent base material.

Further details of the present invention will be explained using examples below.

### Example 1

A transparent surface layer (transparent conductive layer) of ITO (indium tin oxide: 500 nm) was formed by spattering (SP) on the surface of a transparent conductive layer. Then, a resist pattern (side long of a square: 180 µm, pattern interval: 20 µm and thickness: 5 µm) that is opposite to a grid-like pattern (square) was formed on the transparent conductive layer. After that, by spattering (SP), a SP copper oxide layer (black layer: 0.1 µm) and a SP copper layer (metallic layer: 1.0 µm) were formed on the surfaces of the resist pattern and the transparent conductive layer. The formed product was then soaked in a peeling solution to peel off and remove the resist (and the combination of metallic layers formed thereon) to fabricate a transparent electromagnetic radiation shielding material (grid-like pattern with a line width of 20 µm and a line interval of 180 µm) (liftoff method).

This transparent electromagnetic radiation shielding material exhibited high shielding performance of 70 dB (500 MHz) and a high transparency of 70 % expressed as visible light transmittance. This transparent electromagnetic radiation shielding material also exhibited excellent clarity (high degree of blackness of the black layer and excellent uniformity were observed) and excellent adhesion of the black layer and the metallic layer. Especially, remarkably high shielding performance was observed as a result of a synergistic effect with the mesh-like pattern of the black layer and the metallic layer and the transparent conductive layer. Further, since the adhesion of the black layer and the metallic layer was excellent, no peeling off was observed in the mesh portion when forming the mesh-like pattern (when peeling off the resist) or when combining with (adhering to) other functional materials (markedly high production yield was achieved).

### Example 2

A transparent surface layer (transparent inorganic layer) of titanium oxide film (100 nm) was formed by ion plating (IP) on a glass plate. Then, an IP tin oxide layer (black layer: 0.1 µm) and an IP copper layer (metallic layer: 1.0 µm) were formed by ion plating (IP) on the transparent inorganic layer. Thereafter, a grid-like pattern (a line width: 20 µm, a line interval: 180 µm and thickness: 5 µm) of an etching resist was formed on the surfaces of the IP tin oxide/IP copper layer (the combination of metallic layers). The formed product was then soaked in an etching solution at a room temperature (aqueous solution of 20 weight % of ferric chloride/1.75 weight % of hydrochloric acid) for one minute to remove the non-resist portions of the combination of metallic layers and peel off the resist pattern to form a transparent electromagnetic radiation shielding material (having the same pattern, line width and line interval as those of the resist pattern).

This transparent electromagnetic radiation shielding material exhibited high shielding performance of 60 dB (500 MHz) and a high transparency of 75 % expressed as visible light transmittance. This transparent electromagnetic radiation shielding material also exhibited excellent clarity (high degree of blackness of the black layer and excellent uniformity were observed) and excellent adhesion of the black layer and the metallic layer (the degree of blackness of the black layer was slightly poorer than that in Example 1). Especially, since the adhesion of the black layer and the metallic layer was excellent, no peeling off was observed in the mesh portions when forming the mesh-like pattern (when etching is carried out) or when combining with (adhering to) other functional materials (markedly high production yield was achieved).

### Example 3

An alcohol solution of polyvinylbutyral (PVB) (Denkabutyral #6000-C, product of Denki Kagaku Kogyo, Co., Ltd.) was applied by spin coater on a glass plate and dried to form a transparent surface layer (transparent resin layer). The same producing methods and conditions as those in Example 2 were used to fabricate a transparent electromagnetic radiation shielding material except for the method of forming the transparent surface layer.

This transparent electromagnetic radiation shielding material exhibited the same degree of excellence in each performance as that of Example 2.

### Comparative Example 1

A transparent electromagnetic shielding material was fabricated by the same forming methods and using the same conditions as those in Example 1 except that a transparent surface layer (transparent conductive layer) was not formed in this example.

Although this transparent electromagnetic radiation shielding material exhibited the good transparency of 75 % expressed as visible light transmittance, which was slightly higher than that of Example 1, the shielding performance was 60 dB (500 MHz) which was much poorer than that in Example 1. Also, the clarity (high degree of blackness of the black layer) was poorer than that in Example 1 (it was about the same degree of excellence as in Examples 2 and 3). In addition, the adhesion of the black layer and the metallic layer was poorer than that in Example 1. Under some conditions, peeling off was observed in the mesh portions when forming the mesh-like pattern or when combining with other functional materials.

### Comparative Example 2

A printed pattern (a grid-like pattern having a line width of 1 mm, a line interval of 7 mm and a thickness of 20 µm) of silver paste was formed on the transparent conductive layer of Example 1 by screen printing to fabricate a transparent electromagnetic radiation shielding material.

This transparent electromagnetic radiation shielding material exhibited the transparency of 65 % expressed as visible light transmittance, which was poorer than that of Example 1. Also, the shielding performance was extremely low, as low as 15 dB (500 MHz). Further, the clarity was also extremely poor (the pattern in silver was visible which obstructed the view). (The material could not be used for displays such as PDP).

The present invention provides the following advantageous effects:
(1) The limitation of pattern designing is small
(2) The degree of blackness and the definition of the black pattern are high, and their long-term stabilities are also obtained. The clarity is also excellent.
(3) It is easy to connect to earth lead lines.
(4) High conductivity of the metallic layer and high shielding effect are obtained (a high aperture ratio can be set so that a high optical transmittance can be obtained), and its long-term stability is also obtained.
(5) No degradation is observed in performance of the metallic layer at a high temperature and a high humidity.
(6) A wide viewing angle is obtained.
(7) In case that a continuous web (roll type) film is used for a transparent base material, a desired size of the transparent electromagnetic radiation shielding material can be cut out to be adhered to the transparent material so that an inclusion of defect portions can be avoided and production yield is improved.
(8) It is possible to shield a curved surface.
(9) By forming the transparent surface layer on the transparent base material, the adhesion of the black layer and the metallic layer is markedly improved. As a result, production yield is improved and production cost can be significantly reduced. In addition, the limitation of type of usable metallic layer is reduced.
(10) In case that a transparent conductive layer is used for a transparent surface layer, electromagnetic radiation shielding performance is improved as a result of a synergistic effect between the metallic layers and transparent conductive layer. This is greatly advantageous because if this improvement in electromagnetic radiation shielding performance exceeds the desired performance, the aperture ratio of the mesh pattern can be increased to obtain further improvement in the transparency (visible light transmittance).

It is to be understood that although the present invention has been described with regard to preferred embodiments thereof, various other embodiments and variants may occur to those skilled in the art, which are within the scope and spirit of the invention, and such other embodiments and variants are intended to be covered by the following claims.

## Claims

1. A transparent electromagnetic radiation shielding material comprising an identical mesh-pattern laminated layer consisting of a black layer/metallic layer or a metallic layer/black layer or a black layer/metallic layer/black layer, said identical mesh-pattern laminated layer being formed by dry plating in order on a transparent surface layer formed on a transparent base material.

2. The transparent electromagnetic radiation shielding material according to claim 1, wherein said laminated layer is a metallic layer/black layer or a black layer/metallic layer/black layer having a portion of the black layer formed on the metallic layer being removed.

3. The transparent electromagnetic radiation shielding material according to claim 1, wherein said transparent surface layer is a transparent conductive layer.

4. The transparent electromagnetic radiation shielding material according to claim 1, wherein said transparent base material is selected the group consisting of glass, olefine-maleimide copolymer and norbornene resin.

5. The transparent electromagnetic radiation shielding material according to claim 1, wherein said mesh pattern is a grid-like pattern and has a line interval of less than 200 µm and a line width of less than 50 µm.

6. The transparent electromagnetic radiation shielding material according to claim 2, wherein said transparent surface layer is a transparent conductive layer.

7. The transparent electromagnetic radiation shielding material according to claim 2, wherein said transparent base material is selected the group consisting of glass, olefine-maleimide copolymer and norbornene resin.

8. The transparent electromagnetic radiation shielding material according to claim 2, wherein said mesh pattern is a grid-like pattern and has a line interval of less than 200 µm and a line width of less than 50 µm.

9. The transparent electromagnetic radiation shielding material according to claim 3, wherein said transparent conductive layer is formed by dry plating.

10. The transparent electromagnetic radiation shielding material according to claim 3, wherein said transparent base material is glass, olefine-maleimide copolymer or norbornene resin.

11. The transparent electromagnetic radiation shielding material according to claim 3, wherein said mesh pattern is a grid-like pattern and has a line interval of less than 200 µm and a line width of less than 50 µm.

12. The transparent electromagnetic radiation shielding material according to claim 6, wherein said transparent conductive layer is formed by dry plating.

13. The transparent electromagnetic radiation shielding material according to claim 4, wherein said mesh pattern is a grid-like pattern and has a line interval of less than 200 µm and a line width of less than 50 µm.
